# EUROPÄISCHE PATENTSCHRIFT

(11) **EP 0 877 472 B1**
(45) Veröffentlichungstag und Bekanntmachung des Hinweises auf die Patenterteilung: **01.12.2004**
(21) Anmeldenummer: 98810291.9
(22) Anmeldetag: 06.04.1998
(51) Int. Cl.: H02M 7/00

(54) **Stromrichter-Module mit einem Verschienungssystem für Leistungshalbleiterschalter**
Rectifier modules with a bus bar system for power semiconductor switches
Modules de redresseur avec un système de barres omnibus pour commutateurs à semi-conducteur de puissance

(30) Priorität: 09.05.1997 DE 19719648
(43) Veröffentlichungstag der Anmeldung: 11.11.1998
(73) Patentinhaber: Bombardier Transportation GmbH, 13627 Berlin (DE)
(72) Erfinder: Grossmann, Walter, 5200 Brugg (CH); Herbst, Ingo, Dr., 8606 Greifensee (CH); Meyer, Urs, 5400 Baden (CH)
(74) Vertreter: COHAUSZ & FLORACK

(56) Entgegenhaltungen:
- DE-A- 4 402 425
- DE-A- 19 600 367

## Beschreibung

### TECHNISCHES GEBIET

Die Erfindung bezieht sich auf das Gebiet der Leistungselektronik. Sie geht aus von einem Stromrichter-Modul und einem Stromrichter nach dem Oberbegriff der Ansprüche 1 und 10.

### STAND DER TECHNIK

Die Erfindung hat Stromrichter-Module für Hochleistungsstromrichter zum Gegenstand. Die Stromrichter-Module werden aus mehreren Leistungshalbleiterschaltern mittels eines Verschienungssystems aufgebaut. Derartige Verschienungssysteme werden z.B. im Artikel "GTO-Hochleistungsstromrichter für Triebfahrzeuge mit Drehstromantrieb", ABB Technik 4/1995, Seiten 4-13 beschrieben. Die Energieversorgung elektrisch angetriebener Lokomotiven erfolgt über einen Gleichspannungszwischenkreis, der eingangsseitig an ein Gleichspannungsnetz oder über einen Netzstromrichter an ein Wechselstromnetz gekoppelt ist und ausgangsseitig über einen im allgemeinen mehrphasigen Antriebsstromrichter amplituden- und frequenzvariablen Strom an die Drehstrom-Asynchronfahrmotoren liefert. Das Verschienungssystem bildet die elektrische Verbindung zwischen dem Ausgang des Netzstromrichters - oder dem Fahrdraht bei einem Gleichspannungsnetz - und den Leistungshalbleiterschaltern oder -modulen des Antriebsstromrichters. Es kann eine beträchtliche Komplexität aufweisen, die Leistungsfähigkeit des elektrischen Schaltsystems begrenzen und erhebliche Kosten verursachen.

Im Zuge der Entwicklung von Leistungshalbleiterschaltern hat ein Übergang von konventionellen Thyristoren über die Abschaltthyristoren (GTOs) zu den IGBTs (Bipolartransistoren mit isoliertem Gate) stattgefunden. Die IGBTs sind im allgemeinen in einem Modul integriert. Für höhere Ströme bzw. Leistungen werden mehrere Module parallel geschaltet. Im Hinblick auf Stromrichterfamilien verschiedener Leistungen sind solche Verschienungssysteme gesucht, die einen modularen, auf einfache Weise skalierbaren Aufbau eines Mehrphasen-Stromrichters erlauben und niederinduktiv sind.

In zwei früheren, nicht vorveröffentlichten deutschen Patentanmeldungen (Aktenzeichen 196 00 367.9 und 196 12 839.0) wird zur Lösung dieses Problems eine zweidimensionale Anordnung der Leistungshalbleitermodule über flächenhaften Gleichstromblechen und parallel liegenden Phasenschienen vorgeschlagen. Die flachen Module weisen entlang einer schmalen langen Kante langgestreckte Steckkontakte auf und werden parallel zu den Phasenschienen in zwei Reihen pro Schiene in als Gegenstecker wirkende Laschen eingeschoben. Die nächsten Nachbarn sind jeweils um 180° verdreht und in einer Brückenschaltung miteinander verbunden. Sie bilden somit Halbbrücken oder Brückenzweig-Paare, d. h. sie sind mit entgegengesetzten Gleichspannungsblechen kontaktiert und speisen gegenpolige Stromhalbwellen in eine gemeinsame Phasenschiene. Die übernächsten Nachbarn sind hingegen gleich orientiert und bilden parallel geschaltete Module zur Leistungsskalierung.

Diese Konfiguration weist noch Nachteile auf wie z. B. unbefriedigende Symmetrie, nichtideale Induktivität und insbesondere baulicher Aufwand. Die unterschiedlichen und langen Strompfade zu und zwischen den Modulen bedingen Stromasymmetrien und ungleiche Belastungen der Module. Die resultierende suboptimale Auslastung nimmt mit zunehmender Leistung bzw. Anzahl Module pro Phase zu, was eine leistungsmässige Überdimensionierung ("Derating") notwendig macht. Weitere Probleme dieser Anordnung betreffen die konstruktive Seite. Es werden für eine Baureihe viele unterschiedliche Teile benötigt und der Zusammenbau ist aufwendig. Die Einhaltung der minimalen Isolationsabstände und Kriechwege erfordert besondere Sorgfalt, weil sich Plus- und Minusanschlüsse sehr nahekommen und einander durchdringen. Ausserdem sind für jede Anwendung bzw. Leistungsauslegung massgeschneiderte Blechgrössen und individuell angepasste Bauteile erforderlich.

Gemäß der DE 44 02 425 A1 ist es darüberhinaus Stand der Technik, für eine Wechselrichteranordnung mehrere Brückenzweig-Paare von Halbleiter-Schaltelementen entlang einer Phasenschiene parallel zu schalten. Die Elemente jedes Brückenzweigs sind Vorderseite an Rückseite bzw. voneinander abgewandt bzw. gleich orientiert, über Längsprofile kontaktiert und verschraubt. Als Besonderheit ist die Phasenschiene am Ende nach oben umgeklappt und antiparallel zurückgeführt, um die Induktivität zu verringern.

### DARSTELLUNG DER ERFINDUNG

Aufgabe der vorliegenden Erfindung ist es, ein Verschienungssystem für Stromrichter anzugeben, welches sich durch einen vereinfachten, platzsparenden Aufbau und reduzierten Montageaufwand auszeichnet sowie eine verbesserte Symmetrie mit niedrigen Induktivitäten und hoher Stromtragfähigkeit aufweist. Diese Aufgabe wird erfindungsgemäss durch die Merkmale des ersten Anspruchs gelöst.

Kern der Erfindung ist es nämlich, vorzugsweise steckbare Leistungshalbleiterschalter paarweise, mit ihren Vorder- oder Rückseiten einander zugewandt orientiert und sehr dicht benachbart an einen Plus- und Minusanschluss eines Gleichstromzwischenkreises und an eine Phasenschiene anzukoppeln. Dadurch werden die Strompfade sowohl für die Last- als auch Kommutierströme symmetrisiert und niederinduktiv ausgelegt. Dabei werden verschiedene Varianten von Stromrichter-Modulen geschaffen, die einfach montierbar und aufgrund ihres modularen Aufbaus leicht an einen gewünschten Leistungsbedarf anpassbar sind.

Ein erstes Ausführungsbeispiel stellt ein erstes einphasiges Stromrichter-Modul bestehend aus zwei Leistungshalbleiterschaltern dar, die einander mit ihren Vorder- oder Rückseiten frontal gegenüberstehen und in Brückenschaltung verbunden sind.

Ein weiteres Ausführungsbeispiel stellt ein zweites einphasiges Stromrichter-Modul bestehend aus vier Leistungshalbleiterschaltern dar, wobei je zwei Schaltelemente einander gegenüberstehen und in einem Brückenzweig parallelgeschaltet sind und beide Zweige seitlich, d. h. in Richtung der Phasenschiene versetzt, benachbart sind.

Ein letztes Ausführungsbeispiel stellt ein zweiphasiges Stromrichter-Modul bestehend aus vier Leistungshalbleiterschaltern dar, wobei je zwei Schaltelemente in seitlicher, paralleler Position ein Brückenzweig-Paar bilden und beide Paare bezüglich der Mittelebene spiegelbildlich angeordnet sind und unterschiedliche Phasen versorgen.

Ein Vorteil des erfindungsgemässen Verschienungssystems besteht in der hohen Symmetrie der Anordnung der Leistungshalbleiter-Schaltelemente, wodurch eine gleichmässige Strombelastung der Elemente und somit eine hohe Gesamtstromstärke ermöglicht wird.

Speziell vorteilhaft ist es, dass parallel geschaltete Leistungshalbleiter-Schaltelemente aufgrund der kleinen Abstände von einer gemeinsamen Gate-Ansteuerelektronik ("Gate-Drive") weitgehend störungsfrei regelbar sind.

Ein weiterer Vorteil ist darin zu sehen, dass ein sehr einfacher, kompakter und modularer Aufbau eines Stromrichter-Moduls mit wenigen Standardbauteilen und steckbaren Leistungshalbleiter-Schaltelementen realisierbar ist.

### KURZE BESCHREIBUNG DER ZEICHNUNG

Die Erfindung wird nachstehend anhand von Ausführungsbeispielen erläutert. Es zeigen:
- Fig. 1: eine perspektivische Ansicht eines Leistungshalbleiterschalters bzw. Leistungshalbleitermoduls mit langgestreckten Steckkontakten (Stand der Technik);
- Fig. 2: eine schematische Aufsicht von oben auf ein erstes erfindungsgemässes Stromrichter-Modul;
- Fig. 3: Schnitt durch ein erstes Stromrichter-Modul gemäss Fig. 2 entlang der Linie A-A mit aufgesteckten Leistungshalbleitermodulen;
- Fig. 4: eine schematische Aufsicht von oben auf ein zweites erfindungsgemässes Stromrichter-Modul;
- Fig. 5: Schnitt durch ein zweites Stromrichter-Modul gemäss Fig. 4 entlang der Linie B-B mit aufgesteckten Leistungshalbleitermodulen;
- Fig. 6: eine schematische Aufsicht von oben auf ein drittes erfindungsgemässes Stromrichter-Modul.

In den Figuren sind gleiche Teile mit gleichen Bezugszeichen versehen.

### WEGE ZUR AUSFÜHRUNG DER ERFINDUNG

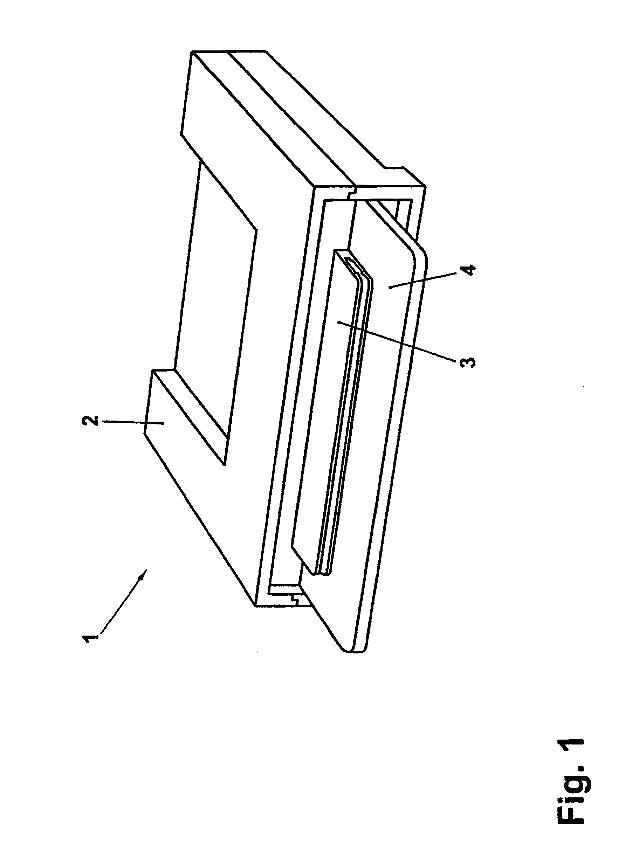

Figur 1 zeigt einen Leistungshalbleiterschalter bzw. ein Leistungshalbleitermodul 1, insbesondere ein "Intelligent Power Module" bzw. IPM, welches in Stromrichtern bzw. Spannungumrichtern bzw. Wechselrichtern Anwendung findet. Der Leistungshalbleiterschalter ist, typischerweise zusammen mit Beschaltungskomponenten, in einem Modulgehäuse 2 untergebracht. Er wird über einen sichtbaren, langgestreckten Steckkontakt 3 (Gleichstromeingang) mit einem Gleichspannungspol und einen durch die Isolierplatte 4 verdeckten Steckkontakt 3 (Phasenausgang) mit der Phase kontaktiert. Die Ober- bzw. Unterseite des Moduls seien als Vorder- bzw. Rückseite oder als frontale Seiten bezeichnet. Die Ansteuerung des Leistungshalbleiters erfolgt über eine hier nicht dargestellte Gate-Elektronik bzw. einen "Gate Drive". Die Module können mit Leistungshalbleitern unterschiedlicher Technologie, vorzugsweise mit IGBTs, bestückt sein. Für Traktionszwecke müssen zur Schaltung grosser Ströme und Leistungen mehrere Module über ein Verschienungssystem zusammengeschaltet werden. Die Weiterentwicklung der IGBTs ist auf weiterhin zunehmende Schaltleistungen ausgerichtet, so dass die Anzahl parallel zu schaltender Module in Zukunft reduziert werden kann.

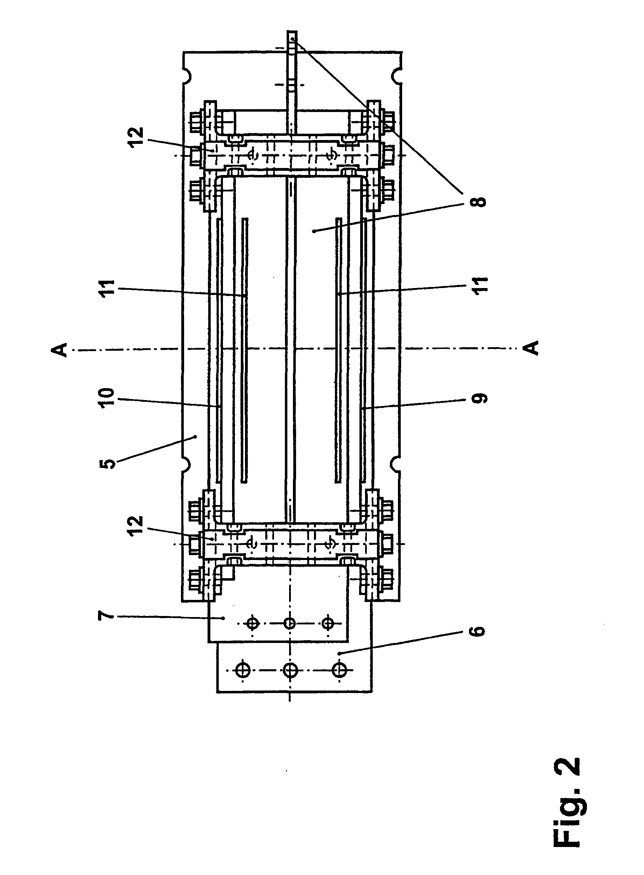

Figur 2 offenbart nun ein erstes Ausführungsbeispiel eines erfindungsgemässen Verschienungssystems, welches für die minimale Anzahl von zwei Leistungshalbleitermodulen pro Phase ausgelegt und bezüglich Schalteigenschaften, Platzersparnis und Einfachheit der Konstruktion optimiert ist. Die Aufsicht zeigt linker Hand einen schienenförmigen Plus- 6 und Minusanschluss 7 für den Anschluss an den Gleichstromzwischenkreis, in der Mitte an beiden Längsseiten erste Laschen 9 bzw. 10 des Plus- bzw. Minusanschlusses sowie zweite Laschen 11 eines Phasenanschlusses 8 und rechter Hand den nach rechts aussen geführten Phasenanschluss bzw. die Phasenabgangsschiene 8. Je eine erste und zweite Lasche wirken zur Aufnahme und Kontaktierung eines Leistungshalbleiterschalters zusammen. Vorzugsweise stehen die Laschen 9, 10, 11 rechtwinklig nach oben ab und sind parallel zu den Längsseiten orientiert, so dass die Schalter dicht beabstandet mit ihren Vorder- oder Rückseiten einander zugewandt gegenüberstehen.

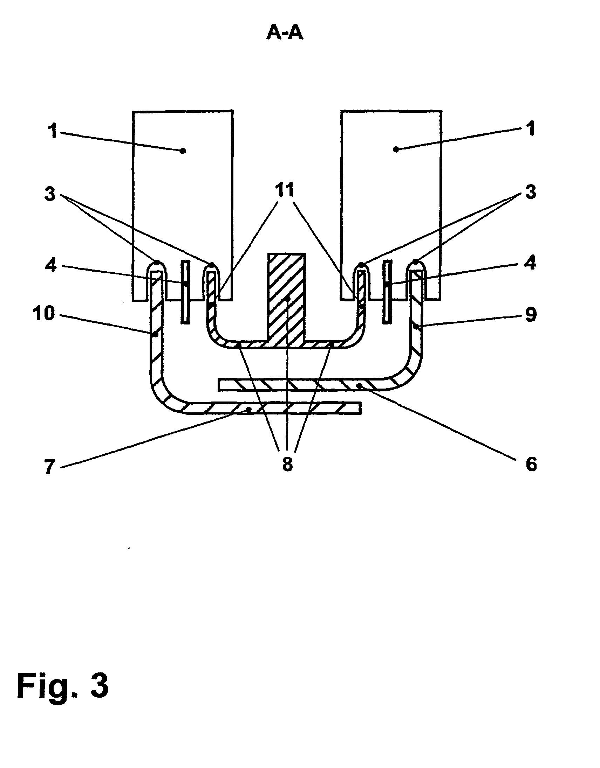

Der Schnitt entlang A-A (Figur 3) verdeutlicht die erfindungsgemässe Anordnung. Es werden die im wesentlichen "L"-förmigen Querschnittsprofile des Plusund Minusanschlusses 6, 7 und das im wesentlichen "W"-förmige Querschnittsprofil der Phasenschiene 8 gezeigt sowie ihr Zusammenwirken mit zwei Leistungshalbleitermodulen 1. Bei der Phasenschiene 8 kann der Mittelgrat mehr oder weniger ausgeprägt sein oder auch fehlen, so dass ein "U"-förmiges Profil vorliegt. Alle Profile sind zusammen mit Halterungen 12 über nicht dargestellte Isolationselemente auf einer Grundplatte 5 befestigt und bilden ein kompaktes Bauelement. Die Halterungen und Isolationselemente können insbesondere auch direkt in die Grundplatte integriert sein. Als Isolationsmedien zwischen den stromtragenden Teilen 6, 7 und 8 kommen Luft, Gas, Feststoffisolatoren oder eine Kombination in Frage, wobei die minimalen Abstände durch entsprechende Isolations- und Kriechwegbedingungen vorgegeben sind. Die Oberflächen können, müssen aber nicht isolierend beschichtet sein. Schliesslich erhält man durch Einfügen zweier Leistungshalbleitermodule 1 von oben ein äusserst kompaktes und mechanisch stabiles Stromrichtermodul.

Diese Anordnung ist in mehrfacher Hinsicht sehr vorteilhaft. Die Strompfade sind sehr breit, kurz und für beide Leistungshalbleiter-Schaltelemente nahezu gleich dimensioniert. Sie umschliessen kleine induktivitätserzeugende Flächen bzw. sind für entgegengesetzte Stromrichtungen dicht beabstandet. Durch diese Massnahmen werden neben einer sehr hohen Stromtragfähigkeit vor allem eine sehr kleine Induktivität von ca. 25 nH im Kommutierkreis erzielt. Als Kommutierung werden dabei die z. T. µs-schnellen Schaltvorgänge bezeichnet, durch welche die Leistungshalbleiter zur gegenseitigen Entlastung hochfrequente Ströme austauschen.

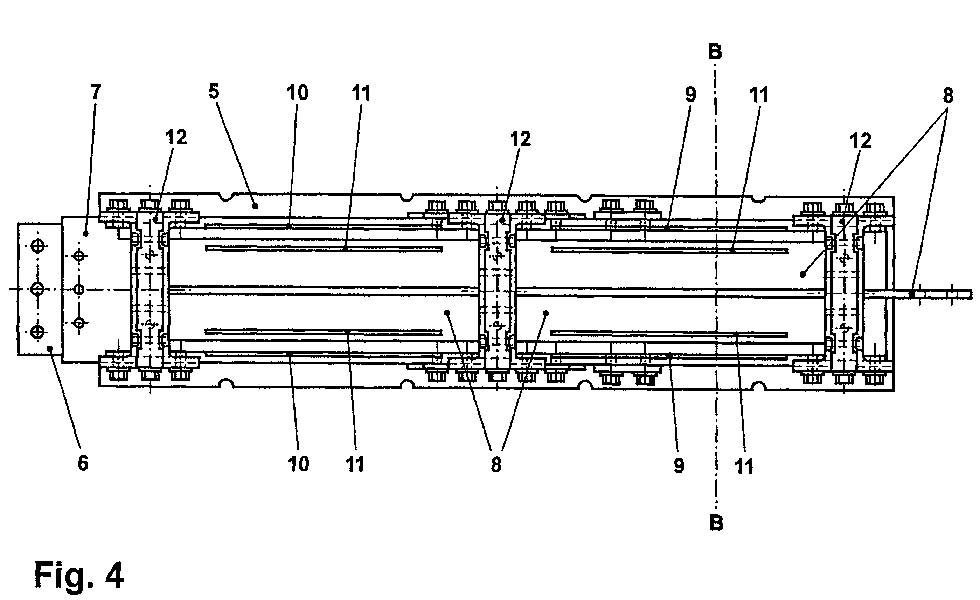

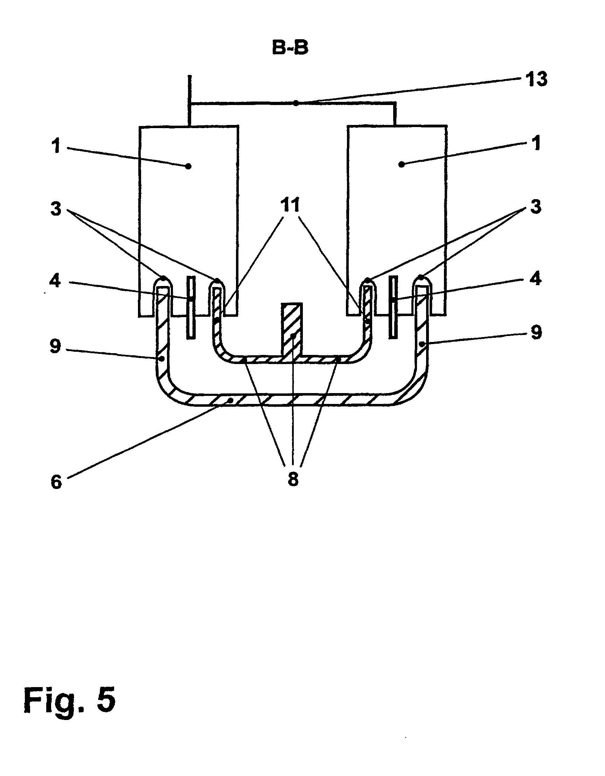

Ein zweites Ausführungsbeispiel ergibt sich aus Figur 4 und der zugehörigen Schnittansicht entlang B-B in Figur 5. Hier weisen der Plus- und Minusanschluss 6, 7 ein im wesentlichen "U"-förmiges Querschnittsprofil mit ersten Laschen 9, 10 an beiden Längsseiten und der Phasenanschluss 8 wieder ein im wesentlichen "W"-förmiges oder "U"-förmiges Querschnittsprofil mit zweiten Laschen 11 an beiden Längsseiten auf. Dieses Stromrichter-Modul besitzt vier Montageplätze für Leistungshalbleiterschalter. Je zwei Leistungshalbleiterschalter stehen mit ihren Vorder- oder Rückseiten einander zugewandt gegenüber und sind parallel geschaltet. Mit dem seitlich benachbarten Paar sind sie in einer Halbbrückenschaltung verbunden.

In dieser Anordnung ist die Symmetrie dahingehend reduziert, dass der Plusanschluss 6 das weiter hinten gelegene Leistungshalbleiterschalter-Paar über die Laschen 9 versorgen muss. Er wird daher von unten über ein flaches Zuführungsblech kontaktiert. Die resultierende Induktivität des Kommutierkreises erreicht mit typischerweise ca. 50 nH aber immer noch sehr niedrige Werte. Ein weitere Vorteil besteht darin, dass jeweils die parallel geschalteten Leistungshalbleiter-Schaltelemente von einem gemeinsamen Gate Drive ansteuerbar sind, da das Problem gefährlicher induzierter Spannungsspitzen aufgrund des sehr kurzen Kabelwegs 13 weitgehend zurückgedrängt ist.

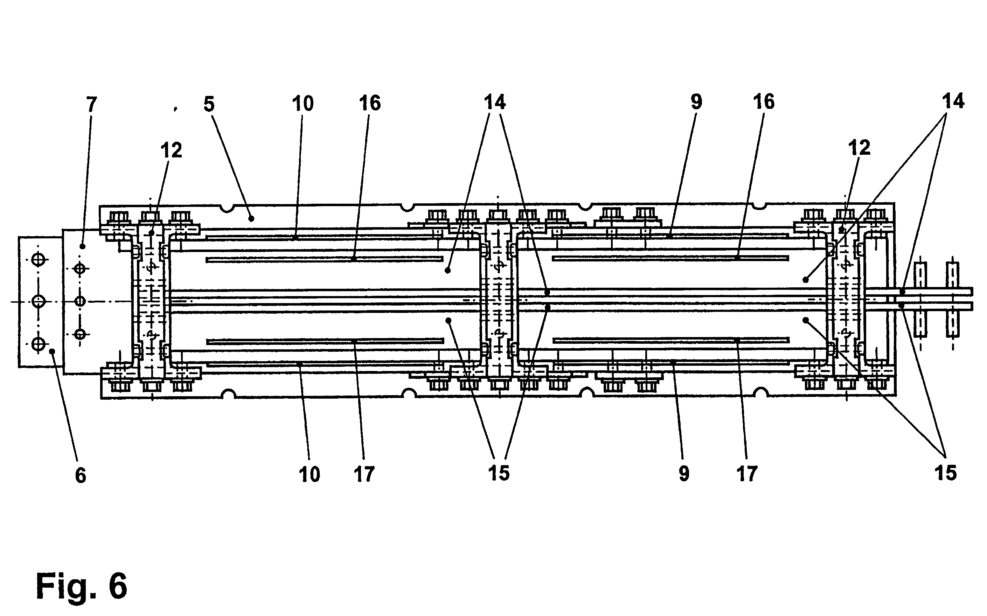

Eine extrem kompakte Anordnung zur Speisung zweier Phasen ist in Figur 6 zu sehen. Diese Anordnung geht aus den Figuren 4 und 5 durch Auftrennung der Phasenschiene 8 entlang ihrer Mittellinie und der Gate-Zuleitung 13 hervor. Die sich ergebenden Phasenschienen 14 und 15 weisen eine halbe Breite und im Bereich der Laschen 16 bzw. 17 ein halbes "W"-förmiges bzw. ein "U"-förmiges Profil auf. Beide Phasenschienen verlaufen in Längsrichtung parallel und liegen dicht nebeneinander. Die an der gleichen Längsseite seitlich versetzt angeordneten, mit unterschiedlichen "U"-Profilen 6, 7 kontaktierten Leistungshalbleiterschalter bilden jeweils eine Halbbrücke und kontaktieren einen Phasenanschluss 14, 15. Die Kommutierströme fliessen, ähnlich wie im zweiten Ausführungsbeispiel, aber für jede Halbbrücke getrennt, in Längsrichtung durch die Verschienungen.

In allen genannten Beispielen zeichnet sich das erfindungsgemässe Verschienungssystem durch wirtschaftlich bedeutsame konstruktive Vorteile aus. Es werden wenige Bauteile eingesetzt, die z. B. aus Aluminium-Strangpressprofilen oder Messing-Biegeteilen mit minimem Bearbeitungsaufwand herstellbar sind. Gleichwohl ist eine sehr gute Einhaltung mechanischer Toleranzen möglich und die Verschienung ist auch für hohe Ströme im kA-Bereich geeignet. Für eine Leistungsskalierung lassen sich die kompakten Stromrichtermodule (Figur 2-6) sehr dicht nebeneinanderpacken und zu grösseren Einheiten zusammenschalten, ohne dass Bauteile angepasst werden müssten.

Die erfindungsgemässen Stromrichter-Module zeichnen sich durch sehr niedrige Induktivitäten aus. Dadurch werden sehr steile Schaltflanken bzw. sehr hohe Schaltfrequenzen realisierbar und die Belastungen der Leistungshalbleiter sowie die Rückwirkungen auf das Netz können klein gehalten werden. Darüberhinaus ermöglichen alle Ausführungsformen ein sehr geringes Derating der Leistungshalbleiter-Schalter. Dies wird durch die hohe Symmetrie der Brückenzweige erreicht. Im Falle parallelgeschalteter Leistungshalbleitermodule wird ein Derating auch dadurch vermieden, dass Potentialdifferenzen zwischen den Gates paralleler Module minimiert sind, indem die Verschienung zwischen den Modulen der Parallelschaltung sehr niederinduktiv und die Gate-Drive-Verbindungsleitungen sehr kurz ausgelegt sind.

Besonders vorteilhaft in allen Ausführungsbeispielen ist die Verwendung steckbarer Leistungshalbleiterschalter bzw. Leistungshalbleitermodule. Die ersten und zweiten Laschen wirken dann als Steckplätze für die Leistungshalbleiterschalter.

In den Beispielen können Plus- 6 und Minusanschluss 7 ihre Rollen vertauschen. Es ist auch denkbar, dass die Gleichspannungsanschlüsse 6, 7 und der Phasenanschluss 8 ihre Anordnung vertauschen (siehe z. B. Fig. 3). Dann tauschen die ersten und zweiten Laschen ihre Plätze, die Leistungshalbleitermodule werden um 180° verdreht montiert und ein verbreiterter Phasenanschluss 8 wird unterhalb der Gleichspannungsanschlüsse herausgeführt.

Weitere Varianten der Erfindung ergeben sich beispielsweise auch dadurch, dass in Längsrichtung statt einem mehrere Leistungshalbleiterschalter in Parallelschaltung angeordnet sind. Dies kann einfach durch längere Laschen oder mehrere, gleich kontaktierte Laschen seitlich nebeneinander erreicht werden. Auf diese Weise ist in allen drei Ausführungsformen (Fig. 2-6) eine Leistungsskalierung möglich. Ebenso können mehrere, auch unterschiedliche Stromrichter-Module zur Leistungsskalierung über ihre Phasenanschlüsse 8, 14, 15 zusammengeschaltet werden.

Insgesamt steht mit der Erfindung ein Verschienungssystem zur Verfügung, durch welches Stromrichter-Module mit optimalen Schalteigenschaften und platzsparender, modularer Bauweise realisierbar sind.

### BEZUGSZEICHENLISTE

- 1: Leistungshalbleiterschalter bzw. Leistungshalbleitermodul
- 2: Modulgehäuse
- 3: Steckkontakt
- 4: Isolierplatte
- 5: Grundplatte
- 6: Plusanschluss
- 7: Minusanschluss
- 8: Phasenanschluss
- 9: erste Laschen (Pluspol)
- 10: erste Laschen (Minuspol)
- 11: zweite Laschen (Phase)
- 12: Halterung
- 13: Gate-Zuleitung
- 14: Phasenanschluss 1
- 15: Phasenanschluss 2
- 16: zweite Laschen (Phase 1)
- 17: zweite Laschen (Phase 2)

## Patentansprüche

1. Stromrichter-Modul mit Leistungshalbleiterschaltern (1) und einem Verschienungssystem, umfassend einen Plusanschluss (6), einen Minusanschluss (7) sowie einen schienenförmigen Phasenanschluss (8, 14, 15), welche unter Zwischenfügung von Isolationselementen aufeinander gestapelt und auf einer Grundplatte (5) befestigt sind, wobei
a) der Plus- (6) und Minusanschluss (7) schienenförmig sind und an einer Längsseite mindestens eine erste abstehende Lasche (9, 10) aufweisen, **dadurch gekennzeichnet, dass**
b) jeder Phasenanschluss (8, 14, 15) an seiner Längsseite mindestens eine zweite abstehende Lasche (11, 17, 18) aufweist,
c) die ersten und zweiten Laschen zur Aufnahme und elektrischen Kontaktierung der Leistungshalbleiterschalter zusammenwirken und
d) je zwei Leistungshalbleiterschalter an gegenüberliegenden Längsseiten der Plus/Minus/Phasenanschlüsse paarweise, mit ihren Vorder- oder Rückseiten einander zugewandt angeordnet sind.

2. Stromrichter-Modul nach Anspruch 1, **dadurch gekennzeichnet, dass**
a) die Schienen in der Reihenfolge Plus/Minus/Phasen-Anschluss oder Minus/Plus/Phasen-Anschluss aufeinandergestapelt sind,
b) die ersten (9, 10) und zweiten (11, 16, 17) Laschen sich in Richtung der Schienen erstrecken und im wesentlichen rechtwinklig nach oben abstehen,
c) die paarweisen Leistungshalbleiterschalter mit ihren Phasenausgängen einander zugewandt orientiert sind und
d) insbesondere die Leistungshalbleiterschalter steckbar sind.

3. Stromrichter-Modul nach Anspruch 2, **dadurch gekennzeichnet, dass**
a) der Plus- (6) und Minusanschluss (7) ein im wesentlichen "L"-förmiges Querschnittsprofil aufweisen,
b) die beiden "L"-Profile (6, 7) so ineinandergestellt sind, dass ihre ersten Laschen (9, 10) sich an entgegengesetzten Längsseiten befinden,
c) der Phasenanschluss (8) ein "W"- oder "U"-förmiges Querschnittsprofil mit zweiten Laschen (11) an beiden Längsseiten aufweist,
d) das "W"- oder "U"-Profil (8) so zwischen den "L"-Profilen (6, 7) befestigt ist, dass die zweiten Laschen (11) längs neben den ersten Laschen (9, 10) angeordnet sind und
e) die paarweisen Leistungshalbleiterschalter in einer Halbbrückenschaltung verbunden sind.

4. Stromrichter-Modul nach Anspruch 3, **dadurch gekennzeichnet, dass**
a) der Plus- (6) und Minusanschluss (7) jeweils genau eine erste Lasche (9, 10) aufweisen,
b) der Phasenanschluss (8) genau zwei zweite Laschen (11) aufweist und
c) genau zwei Leistungshalbleiterschalter kontaktiert sind.

5. Stromrichter-Modul nach Anspruch 2, **dadurch gekennzeichnet, dass**
a) der Plus- (6) und Minusanschluss (7) ein erstes im wesentlichen "U"-förmiges Querschnittsprofil mit ersten Laschen (9, 10) an beiden Längsseiten aufweisen,
b) die beiden ersten "U"-Profile (6, 7) hintereinander angeordnet sind, wobei das in Längsrichtung weiter hinten angeordnete Profil zur Kontaktierung mit dem Gleichstromzwischenkreis ein flaches Zuführungsblech umfasst,
c) der Phasenanschluss (8) ein "W"- oder zweites "U"-förmiges Querschnittsprofil mit zweiten Laschen (11) an beiden Längsseiten aufweist,
d) das "W"- oder zweite "U"-Profil (8) so zwischen den beiden ersten "U"-Profilen (6, 7) befestigt ist, dass seine Laschen (11) längs neben den Laschen (9, 10) der ersten "U"-Profile angeordnet sind und
e) die über gleiche erste "U"-Profile kontaktierten Paare von Leistungshalbleiterschaltern in einer Parallelschaltung und die über ungleiche erste "U"-Profile kontaktierten Paare in einer Halbbrückenschaltung verbunden sind.

6. Stromrichter-Modul nach Anspruch 5, **dadurch gekennzeichnet, dass**
a) der Plus- (6) und Minusanschluss (7) jeweils genau zwei einander gegenüberliegende Laschen (9, 10) an beiden Längsseiten aufweisen,
b) der Phasenanschluss (8) genau vier Laschen (11) aufweist und
c) genau zwei Paare von Leistungshalbleiterschaltern kontaktiert sind.

7. Stromrichter-Modul nach Anspruch 2, **dadurch gekennzeichnet, dass**
a) der Plus- (6) und Minusanschluss (7) ein im wesentlichen "U"-förmiges Querschnittsprofil mit ersten Laschen (9, 10) an beiden Längsseiten aufweisen,
b) die beiden "U"-Profile (6, 7) hintereinander angeordnet sind, wobei das in Längsrichtung weiter hinten angeordnete Profil zur Kontaktierung mit dem Gleichstromzwischenkreis ein flaches Zuführungsblech umfasst,
c) zwei in Längsrichtung parallel verlaufende Phasenanschlüsse (14, 15) dicht nebeneinander liegen und jeweils ein halbes "W"-förmiges Querschnittsprofil aufweisen,
d) jedes halbe "W"-Profil (14, 16) zweite Laschen (16, 17) an seiner vom anderen Phasenanschluss abgewandten Längsseite aufweist,
e) jedes halbe "W"-Profil (14, 15) so zwischen den "U"-Profilen (6, 7) befestigt ist, dass seine zweiten Laschen (16, 17) längs neben den ersten Laschen (9, 10) der "U"-Profile angeordnet sind und
f) die an der gleichen Längsseite angeordneten, mit unterschiedlichen "U"-Profilen kontaktierten Leistungshalbleiterschalter eine Halbbrükke bilden und genau einen Phasenanschluss (14, 15) kontaktieren.

8. Stromrichter-Modul nach Anspruch 7, **dadurch gekennzeichnet, dass**
a) der Plus- (6) und der Minusanschluss (7) jeweils genau zwei Laschen (9, 10) aufweisen,
b) jeder Phasenanschluss (14, 15) genau zwei Laschen (16, 17) aufweist und
c) genau vier Leistungshalbleiterschalter kontaktiert sind.

9. Stromrichter-Modul nach einem der Ansprüche 1-8, **dadurch gekennzeichnet, dass**
a) die Plus- (6), Minus- (7) und Phasenanschlüsse (8, 14, 15) für minimale Induktivität sehr dicht übereinander gestapelt sind und
b) als Isolationsmedien Luft, Gas oder Feststoffisolation oder eine Kombination dieser Medien vorgesehen sind.

10. Stromrichter mit einem Zwischenkreis, daran angeschlossenen Brückenzweigen und ausgangsseitigen Phasenanschlüssen, **dadurch gekennzeichnet, dass**
a) die elektrische Verbindung zwischen dem Zwischenkreis und den Phasenanschlüssen Stromrichter-Module nach einem der vorstehenden Ansprüche umfasst und
b) insbesondere eine Anzahl der gemäss einem der vorstehenden Ansprüche verschienten Stromrichtermodule nach Massgabe der Anzahl Phasenanschlüsse und einer geforderten Leistung des Stromrichters bzw. einer Anzahl parallel zu schaltender Leistungshalbleiterschalter oder Leistungshalbleitermodule zusammengeschaltet ist.

## Claims

1. A converter module having power semiconductor switches (1) and a busbar system, comprising a positive connection (6), and negative connection (7) and a phase connection (8, 14, 15) which is in the form of a busbar, which connections are stacked one on top of the other with the interposition of insulating elements and are mounted on a baseplate (5), wherein
a) the positive connection (6) and the negative connection (7) are in the form of busbars and have at least one first projecting lug (9, 10) on one longitudinal side,
**characterized in that**
b) each phase connection (8, 14, 15) has at least one second projecting lug (II, 17, 18) on its longitudinal side,
c) the first and the second lugs interact for receiving and electrically contacting the power semiconductor switches, and
d) in each case two power semiconductor switches are arranged in pairs on opposite longitudinal sides of the positive/negative/phase connections, with their front or rear sides facing one another.

2. The converter module according to claim 1, **characterized in that**
a) the busbars are stacked one on top of the other in the sequence positive/negative/phase connection or negative/positive/phase connection,
b) the first lugs (9, 10) and the second lugs (11, 16, 17) extend in the direction of the busbars and project upward essentially at right angles,
c) the pairs of power semiconductor switches are oriented with their phase outputs facing one another, and,
d) in particular, the power semiconductor switches are pluggable.

3. The converter module according to claim 2, **characterized in that**
a) the positive connection (6) and the negative connection (7) have an essentially "L"-shaped cross-sectional profile,
b) the two "L"-profiles (6, 7) are interleaved with one another such that their first lugs (9, 10) are on opposite longitudinal sides,
c) the phase connection (8) has a "W"- or "U"-shaped cross-sectional profile with two lugs (11) on both longitudinal sides,
d) the "W"- or "U"-profile (8) is mounted between the "L"-profiles (6, 7) such that the second lugs (11) are arranged longitudinally next to the first lugs (9, 10), and
e) the pairs of power semiconductor switches are connected in a half-bridge circuit.

4. The converter module according to claim 3, **characterized in that**
a) the positive connection (6) and negative connection (7) each have exactly one first lug (9, 10),
b) the phase connection (8) has exactly two second lugs (11), and
c) exactly two power semiconductor switches are made contact with.

5. The converter module according to claim 2, **characterized in that**
a) the positive connection (6) and the negative connection (7) have a first essentially "U"-shaped cross-sectional profile with first lugs (9, 10) on both longitudinal sides,
b) the two first "U"-profiles (6, 7) are arranged one behind the other, the profile which is arranged further to the rear in the longitudinal direction comprising a flat feed plate for making contact with the DC intermediate circuit,
c) the phase connection (8) has a "W"- or second "U"-shaped cross-sectional profile with second lugs (11) on both longitudinal sides,
d) the "W"- or second "U"-profile (8) is mounted between the two first "U"-profiles (6, 7) such that its lugs (11) are arranged longitudinally next to the lugs (9, 10) of the first "U"-profiles, and
e) the pairs of power semiconductor switches which are made contact with via the same first "U"-profiles are connected in a parallel circuit, and the pairs which are made contact with via different first "U"-profiles are connected in a half-bridge circuit.

6. The converter module according to claim 5, **characterized in that**
a) the positive connection (6) and the negative connection (7) each have exactly two mutually opposite lugs (9, 10) on both longitudinal sides,
b) the phase connection (8) has exactly four lugs (11), and
c) exactly two pairs of power semiconductor switches are made contact with.

7. The converter module according to claim 2, **characterized in that**
a) the positive connection (6) and negative connection (7) have an essentially "U"-shaped cross-sectional profile with first lugs (9, 10) on both longitudinal sides,
b) the two "U" profiles (6, 7) are arranged one behind the other, the profile which is arranged further to the rear in the longitudinal direction comprising a flat feed plate in order to make contact with the DC intermediate circuit,
c) two phase connections (14, 15) which run parallel in the longitudinal direction lie closely side-by-side and each has a half "W"-shaped cross-sectional profile,
d) each half "W"-profile (14,15) has second lugs (16, 17) on its longitudinal side facing away from the other phase connection,
e) each half "W"-profile (14, 15) is mounted between the "U"-profiles (6, 7) such that its second lugs (16, 17) are arranged longitudinally next to the first lugs (9, 10) of the "U"-profiles, and
f) the power semiconductor switches which are arranged on the same longitudinal side but make contact with different "U"-profiles form a half-bridge and make contact with exactly one phase connection (14, 15).

8. The converter module according to claim 7, **characterized in that**
a) the positive connection (6) and the negative connection (7) each have exactly two lugs (9, 10),
b) each phase connection (14, 15) has exactly two lugs (16, 17), and
c) exactly four power semiconductor switches are made contact with.

9. The converter module according to any one of claims 1 - 8, **characterized in that**
a) the positive connection (6), negative connection (7) and phase connections (8, 14, 15) are stacked very closely one above the other for minimum inductance, and
b) air, gas or solid insulation, or a combination of these media, are provided as insulation media.

10. A converter having an intermediate circuit, bridge arms connected thereto and phase connections on the output side, **characterized in that**
a) the electrical connection between the intermediate circuit and the phase connections comprises converter modules according to any one of the preceding claims, and,
b) in particular, a number of converter modules with busbars according to any one of the preceding claims, are interconnected, corresponding to the number of phase connections and a required rating of the converter, or corresponding to a number of power semiconductor switches or power semiconductor modules to be connected in parallel.

## Revendications

1. Module de convertisseur comportant des interrupteurs à semi-conducteurs de puissance (1) et un système de barres collectrices, comprenant une connexion positive (6), une connexion négative (7) ainsi qu'une connexion de phase (8, 14, 15) en forme de barres, lesquelles sont empilés les unes sur les autres en intercalant des éléments d'isolation et fixées sur un socle (5), dans lequel
a) les connexion positive (6) et négative (7) sont en forme de barres et présentent sur un côté longitudinal une première éclisse (9, 10) qui s'écarte,
**caractérisé en ce que**
b) chaque connexion de phase (8, 14, 15) présente sur son côté longitudinal au moins une deuxième éclisse (11, 17, 18) qui s'écarte,
c) la première et la deuxième éclisse agissent conjointement pour recevoir et contacter électriquement les interrupteurs à semi-conducteurs de puissance,
d) deux interrupteurs à semi-conducteurs de puissance sont disposés chacun à des côtés longitudinaux opposés des connexions positive/ négative/ de phase en formant des paires, leurs côtés avant ou arrière étant tournés les uns vers les autres.

2. Module de convertisseur selon la revendication 1, **caractérisé en ce que**
a) les barres sont empilées les unes sur les autres en séquence connexion positive/ négative/ de phase ou connexion négative/ positive/ de phase,
b) les premières (9, 10) et deuxièmes (11, 16, 17) éclisses s'étendent dans la direction des barres et s'écartent essentiellement perpendiculairement vers le haut,
c) les paires d'interrupteurs à semi-conducteurs de puissance sont orientées de manière à être tournées l'une vers l'autre avec leurs sorties de phase et,
d) notamment, les interrupteurs à semi-conducteurs de puissance sont enfichables.

3. Module de convertisseur selon la revendication 2, **caractérisé en ce que**
a) la connexion positive (6) et la connexion négative (7) présentent essentiellement un profil de section transversale en forme de "L",
b) les deux profils en forme de "L" (6, 7) sont disposés l'un dans l'autre, de telle sorte que leurs premières éclisses (9, 10) se trouvent sur des côtés longitudinaux opposés,
c) la connexion de phase (8) présente un profil de section transversale en forme de "W" ou "U" avec des deuxièmes éclisses (11) sur ses deux côtés longitudinaux,
d) le profil en forme de "W" ou "U" (8) est fixé entre les profils en forme de "L" (6,7), de telle sorte que les deuxièmes éclisses (11) soient disposées longitudinalement à côté des premières éclisses (9, 10),
e) les paires d'interrupteurs à semi-conducteurs de puissance sont réunies dans un circuit en demi-pont.

4. Module de convertisseur selon la revendication 3, **caractérisé en ce que**
a) la connexion positive (6) et la connexion négative (7) présentent respectivement et exactement une première éclisse (9, 10),
b) la connexion de phase (8) présente exactement deux deuxièmes éclisses (11) et
c) exactement deux interrupteurs à semi-conducteurs de puissance sont contactés.

5. Module de convertisseur de puissance selon la revendication 2, **caractérisé en ce que**
a) la connexion positive (6) et la connexion négative (7) présentent un premier profil de section transversale essentiellement en forme de "U" avec des premières éclisses (9, 10) sur les deux côtés longitudinaux,
b) les deux premiers profils en forme de "U" (6, 7) sont disposés l'un derrière l'autre, le profil disposé le plus à l'arrière dans la direction longitudinale comprenant une lame de transfert plate pour contacter le circuit intermédiaire à courant continu,
c) la connexion de phase (8) présente un profil de section transversale en forme de "W" ou un deuxième profil en forme de "U" avec des deuxièmes éclisses (11) sur ses deux côtés longitudinaux,
d) le profil en forme de "W" ou le deuxième profil en forme de "U" (8) est fixé entre les deux premiers profils en forme de "U" (6, 7) de telle sorte que ses éclisses (11) soient disposées dans le sens de la longueur à côté des éclisses (9, 10) du premier profil en forme de "U" et
e) les paires d'interrupteurs à semi-conducteurs contactés par les premiers profils en "U" identiques sont reliées dans un circuit parallèle et les paires d'interrupteurs à semi-conducteurs contactés par les premiers profils en "U" non identiques sont reliées dans un circuit en demi-pont.

6. Module de convertisseur selon la revendication 5, **caractérisé en ce que**
a) la connexion positive (6) et la connexion négative (7) présentent respectivement et exactement deux éclisses (9, 10) qui se font face sur deux côtés longitudinaux,
b) la connexion de phase (8) présente exactement quatre éclisses (11) et
c) exactement deux paires d'interrupteurs à semi-conducteurs de puissance sont contactées.

7. Module de convertisseur selon la revendication 2, **caractérisé en ce que**
a) les connexions positive (6) et négative (7) présentent un profil de section transversale essentiellement en forme de "U" avec des premières éclisses (6, 10) sur les deux côtés longitudinaux,
b) les deux premiers profils en forme de "U" (6, 7) sont disposés l'un derrière l'autre, le profil disposé le plus à l'arrière dans la direction longitudinale comprenant une lame de transfert plate pour contacter le circuit intermédiaire à courant continu,
c) deux connexions de phase (14, 15) s'étendant parallèlement dans le sens de la longueur reposent l'une à côté de l'autre à faible distance et présentent respectivement un demi profil de section transversale en forme de "W",
d) chaque demi profil en forme de "W" (14, 15) présente des deuxièmes éclisses (16, 17) sur son côté longitudinal détourné de l'autre connexion de phase,
e) chaque demi profil en forme de "W"(14, 15) est fixé entre les profils en forme de "U" (6, 7) de telle sorte que ses deuxièmes éclisses (16, 17) soient disposées dans le sens de la longueur à côté des premières éclisses (9, 10) des profils en forme de "U" et
f) les interrupteurs à semi-conducteurs de puissance disposés sur le même côté longitudinal et contactés par des profils en forme de "U" différents forment un demi-pont et contactent exactement une connexion de phase (14, 15).

8. Module de convertisseur selon la revendication 7, **caractérisé en ce que**
a) la connexion positive (6) et la connexion négative (7) présentent respectivement et exactement deux éclisses (9, 10),
b) chaque connexion de phase (14, 15) présente exactement deux éclisses (16, 17) et
c) exactement quatre interrupteurs à semi-conducteurs sont contactés.

9. Module de convertisseur selon une quelconque des revendications 1 - 8, **caractérisé en ce que**
a) la connexion positive (6), la connexion négative (7) et la connexion de phase (8, 14, 15) sont empilées les unes sur les autres en à très faible distance pour une inductivité minimale et
b) comme moyen d'isolation, une isolation par de l'air, un gaz ou un matériau solide ou une combinaison de ces moyens est prévue.

10. Convertisseur de puissance comportant un circuit intermédiaire, des embranchements de pont raccordés à ce dernier et des connexions de phase de sortie, **caractérisé en ce que**
a) la liaison électrique entre le circuit intermédiaire et les connexions de phase comprend des modules de convertisseur selon une quelconque des revendications précédentes et,
b) notamment, une pluralité de modules de convertisseur de puissance câblés électriquement conformément à une quelconque des revendications précédentes sont branchés ensemble conformément à la pluralité de connexions de phase et à une puissance requise du convertisseur de puissance ou, respectivement, conformément à une pluralité d'interrupteurs à semi-conducteurs de puissance ou de modules d'interrupteurs à semi-conducteurs de puissance branchés en parallèle.
